# EUROPEAN PATENT APPLICATION

(11) **EP 1 650 637 A2**
(43) Date of publication of application: **26.04.2006**
(21) Application number: 05256445.7
(22) Date of filing: 18.10.2005
(51) Int. Cl.: G06F 1/18

(54) **A drive bay cover for computer**

(30) Priority: 21.10.2004 US 970893
(71) Applicant: Hewlett-Packard Development Company, L.P., Houston, TX 77070 (US)
(72) Inventor: Ng, Kai Ming, San Jose, CA 95139 (US)
(74) Representative: Jehan, Robert

(57) **Abstract**

A drive bay cover (422) for reducing high frequency electromagnetic interference (EMI) emissions covers a bay (420) of a computer system chassis (410) by coupling to the computer system chassis (410). At least one edge of the drive bay cover (422) provides a serrated edge (530) such that a gap between the serrated edge (530) and a second edge is less than a wavelength of an EMI emission.

## Description

Embodiments of the present invention relate to the field of computer system housings. Specifically, embodiments of the present invention relate to a drive bay cover for reducing high frequency electromagnetic interference (EMI) emissions.

Electromagnetic interference (EMI) is an electrical disturbance that causes the disruption of operation of an electronic device when it is in the vicinity of an electromagnetic (EM) field. The electrical disturbance may be caused by high frequency waves in the radio frequency (RF) range from microchips or other electronic devices. For example, the internal circuits and electronic components of personal computer systems can generate EM fields in the RF range that may disrupt the operation of neighboring electronic devices.

There are a number of electronic devices that can fail to function properly in the presence of EMI, such as cordless telephones, computers, consumer electronics devices, and even certain medical devices. In order to reduce EMI emissions from personal computer systems, the electronic componentry of a typical computer system is housed within a metal chassis. The metal chassis blocks a large percentage of EMI emissions. The metal chassis may include a number of openings (e.g., vents, connector holes, etc.). However, these openings are typically small enough such that only EMI emissions having very short wavelengths may escape the chassis. These short wavelength EMI emissions are typically less disruptive to electronic devices proximate the computer system.

However, a metal chassis typically has a number of openings for drive bays (e.g., 3.5 inch drive bays and 5.25 inch drive bays) for holding various types of drives. These drive bay openings are often big enough to allow larger wavelength EMI emissions that are more disruptive to electronic devices to escape the metal chassis. In order to reduce these EMI emissions, drive bay covers, also referred to as knockout plates and knockout shield, are placed over the drive bay opening to block a portion of the EMI emissions. However, there are typically gaps between edges of adjacent drive bay covers or a drive bay cover and an adjacent edge of the metal chassis. For example, there is typically a gap between the drive bay cover of an unused bay and the drive of an adjacent drive bay, so as to not interfere with the placement and installation of the drive. This gap is typically long enough so that large wavelength EMI emissions can escape the metal chassis, and interfere with the operation of neighboring electronic devices.

Another prior solution for reducing EMI emissions escaping through drive bay openings is to use permanently attached knockout shields as drive bay covers. These knockout shields are manufactured into the chassis. For example, the knockout shields may be molded into the chassis using perforations in the metal of the chassis. However, these knockout shields are very difficult to remove. Typically, they can only be removed at the time the computer system is assembled. At any time after assembly, removing the knockout shield may damage the electronic componentry of the computer system. Furthermore, once the knockout shield is removed, it cannot be reconnected to the chassis, requiring the use of a conventional drive bay cover, and thus allowing for large wavelength EMI emissions to escape the chassis, as described above.

The present invention seeks to provide an improved drive bay cover, improved computer system chassis and improved computer system.

According to an aspect of the present invention there is provided a drive bay cover as specified in claim 1.

According to another aspect of the present invention there is provided a computer system housing as specified in claim 8.

Various embodiments of the present invention, drive bay cover for reducing high frequency electromagnetic interference (EMI) emissions, are described. The drive bay cover is for covering a bay of a computer system chassis by coupling to the computer system chassis. A at least one edge of the drive bay cover is a serrated edge such that a gap between the serrated edge and a second edge is less than a wavelength of an EMI emission.

Embodiments of the present invention are described below, by way of example only, with reference to the accompanying drawings, in which:
FIGURE 1A is a perspective diagram of the exterior an exemplary computer system housing, in accordance with an embodiment of the present invention.
FIGURE 1 B is a perspective diagram of a portion of the interior of an exemplary computer system housing, in accordance with an embodiment of the present invention.
FIGURE 2 is a diagram of a front view of a computer system chassis, in accordance with an embodiment of the present invention.
FIGURE 3 is a block diagram of electronic components of an exemplary computer system platform, in accordance with an embodiment of the present invention.
FIGURE 4 is a diagram of a front view of a computer system chassis including multiple drive bay covers having serrated edges, in accordance with an embodiment of the present invention.
FIGURE 5A is a diagram of a front view of a computer system chassis including a drive bay cover having a serrated edge and a bay having a serrated edge, in accordance with an embodiment of the present invention.
FIGURE 5B is a diagram of a front view of a computer system chassis including a drive bay cover having a serrated edge and a bay having a linear edge, in accordance with an embodiment of the present invention.
FIGURE 6A is a diagram of a drive bay cover having a serrated edge and with rectangular serrations.
FIGURE 6B is a diagram of a drive bay cover having a serrated edge and with triangular serrations.
FIGURE 6C is a diagram of a drive bay cover having a serrated edge and with sinusoidal serrations.

Reference will now be made in detail to various embodiments of the invention, examples of which are illustrated in the accompanying drawings. While the invention will be described in conjunction with these embodiments, it will be understood that they are not intended to limit the invention to these embodiments. On the contrary, the invention is intended to cover alternatives, modifications and equivalents, which may be included within the scope of the invention as defined by the appended claims. Furthermore, in the following description, numerous specific details are set forth in order to provide a thorough understanding of the teachings herein. In other instances, well-known methods, procedures, components, and circuits have not been described in detail as not to unnecessarily obscure aspects of the present invention.

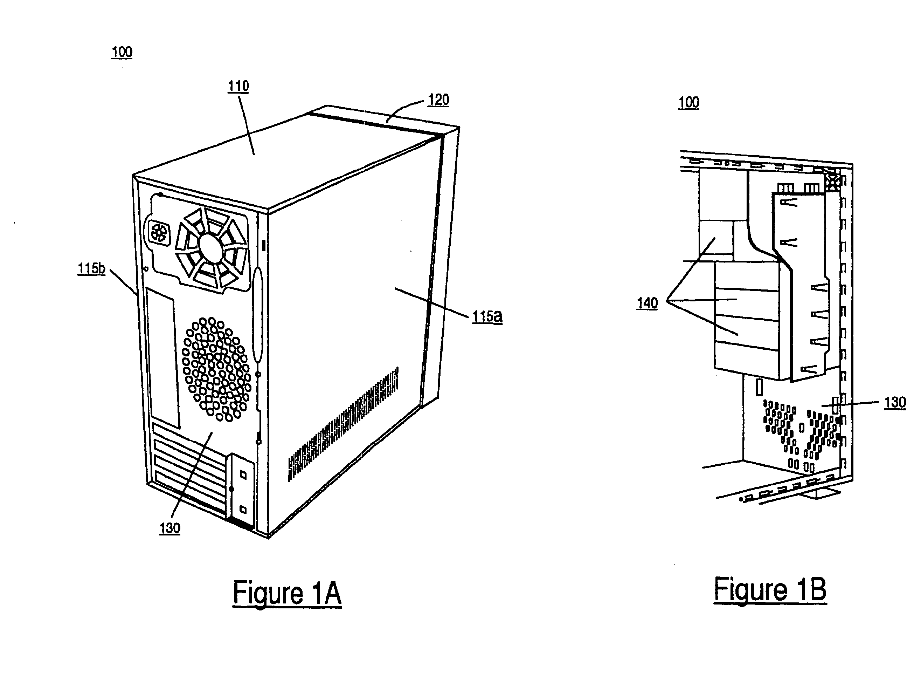

Figure 1A is a perspective diagram of the exterior an exemplary computer system housing 100, in accordance with an embodiment of the present invention. As shown, computer system housing 100 includes top panel 110, side panels 115a and 115b, and front panel (e.g., bezel) 120 secured to chassis 130. In one embodiment, side panel 115a and front panel 120 are removably attached to chassis 130 for allowing access to the interior of computer system housing 100. In one embodiment, chassis 130 is metal and top panel 110 and side panels 115a and 115b include a metal layer for encasing the interior of computer system housing 100 in metal for limiting the electromagnetic interference (EMI) emissions of the electronic componentry of the computer system from escaping computer system housing 100.

Figure 1B is a perspective diagram of a portion of the interior of an exemplary computer system housing 100, in accordance with an embodiment of the present invention. As shown, the front panel of chassis 130 is connected to a number of drive bays 140. Drive bays 140 are for holding various drives, including by not limited to CD-ROM drives, floppy disk drives, USB drives, and other removable media drives. It should be appreciated that drive bays 140 may be configured to hold any type or size of drive (e.g., any 5.25 inch drive or 3.5 inch drive).

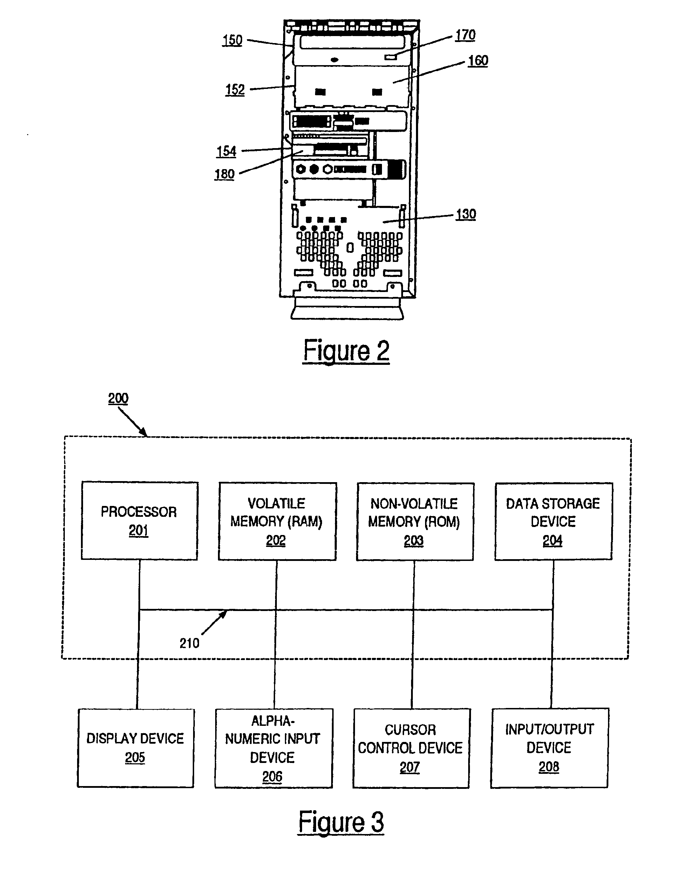

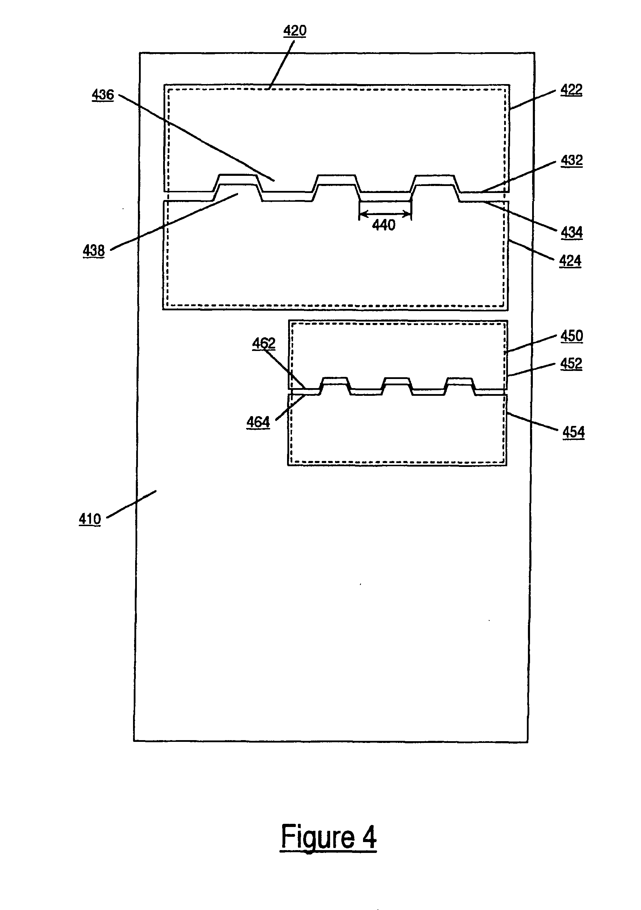

Figure 2 is a diagram of a front view of a computer system chassis 130, in accordance with an embodiment of the present invention. Chassis 130 includes a number of drive bay openings 150, 152 and 154 for allowing a drive to be placed into a corresponding drive bay (e.g., drive bay 140 of Figure 1B). As shown, 5.25 inch drive 170 is placed in drive 10 bay opening 150 and 3.5 inch drive 180 is placed in drive bay opening 154. Drive bay opening 152 is covered by drive bay cover 160. It should be appreciated that drive bay cover 160 may also be referred to as a bay cover, a knockout shield, or a knockout plate. As described below in Figures 4, 5A, 5B, 6A, 6B and 6C, at least one edge of drive bay cover 160 is a serrated edge such that a gap between the serrated edge and a second edge is less than a wavelength of a high frequency EMI emission.

Computer system housing 100 of Figures 1A and 1B is also configured to hold the electronic components of a computer system. Figure 3 is a block diagram of electronic components of an exemplary computer system 200, in accordance with an embodiment of the present invention. In general, computer system 200 includes bus 210 for communicating information, processor 201 coupled with bus 210 for processing information and instructions, random access (volatile) memory (RAM) 202 coupled with bus 210 for storing information and instructions for processor 201, read-only (non-volatile) memory (ROM) 203 coupled with bus 210 for storing static information and instructions for processor 201, data storage device 204 such as a magnetic or optical disk and disk drive coupled with bus 210 for storing information and instructions. In one embodiment, data storage device 204 is configured to be held in a drive bay 140 of Figure 1 B.

In one embodiment, computer system 200 comprises an optional user output device such as display device 205 coupled to bus 210 for displaying information to the computer user, an optional user input device such as alphanumeric input device 206 including alphanumeric and function keys coupled to bus 210 for communicating information and command selections to processor 201, and an optional user input device such as cursor control device 207 coupled to bus 210 for communicating user input information and command selections to processor 201. Furthermore, an optional input/output (I/O) device 208 is used to couple computer system 200 onto, for example, a network.

Display device 205 utilized with computer system 200 may be a liquid crystal device, cathode ray tube, or other display device suitable for creating graphic images and alphanumeric characters recognizable to the user. Cursor control device 207 allows the computer user to dynamically signal the two-dimensional movement of a visible symbol (pointer) on a display screen of display device 205. Many implementations of the cursor control device are known in the art including a trackball, mouse, joystick or special keys on alphanumeric input device 206 capable of signaling movement of a given direction or manner of displacement. It is to be appreciated that the cursor control 207 also may be directed and/or activated via input from the keyboard using special keys and key sequence commands. Alternatively, the cursor may be directed and/or activated via input from a number of specially adapted cursor directing devices.

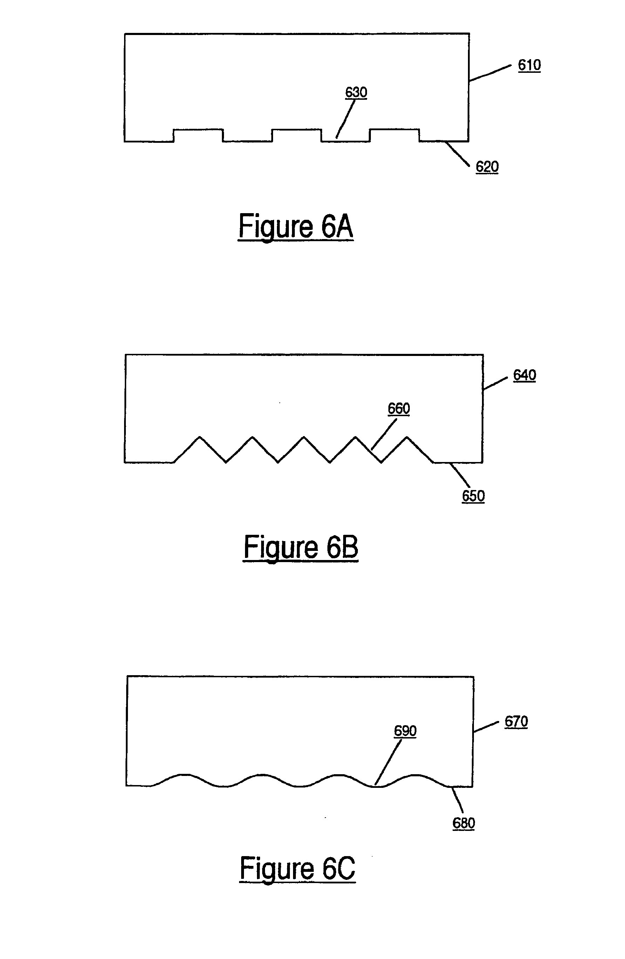

Figure 4 is a diagram of a front view of a computer system chassis 410 including multiple drive bay covers having serrated edges, in accordance with an embodiment of the present invention. Chassis 410 includes drive bay opening 420. In one embodiment, drive bay opening 420 is configured to provide access to two 5.25 inch drive bays. Drive bay cover 422 covers an upper portion of drive bay opening 420 and drive bay cover 424 covers a lower portion of drive bay opening 420. Edge 432 of drive bay cover 422 is a serrated edge with trapezoidal serrations 436 and edge 434 of drive bay cover 424 is a serrated edge with trapezoidal serrations 438. It should be appreciated that edges 432 and 434 may include 5 serrations of other geometries, as described below in conjunction with Figures 6A, 6B and 6C.

Drive bay covers 422 and 424 are configured to be connected to chassis 410 for covering portions of drive bay opening 420. In one embodiment, drive bay covers 422 and 424 are configured to be connected to chassis 410 by a connector, such as a screw, a rivet, a locking tab, or any other connector means. Edge 432 is adjacent to edge 434, such that a gap between edge 432 and 434 is less than a wavelength of a high frequency EMI emission. For example, double-sided arrow 440 represents the longest straight length of the gap between edges 432 and 434. The length of double-sided arrow 440 is less than a wavelength of a high frequency EMI emission. Therefore, high frequency EMI emissions are not able to escape through chassis 410 through drive bay opening 420.

In one embodiment, chassis 410 also includes drive bay opening 450. In one embodiment, drive bay opening 450 is configured to provide access to two 3.5 inch drive bays. Drive bay cover 452 covers an upper portion of drive bay opening 450 and drive bay cover 454 covers a lower portion of drive bay opening 450. Edge 462 of drive bay cover 452 is a serrated edge with trapezoidal serrations and edge 464 of drive bay cover 454 is a serrated edge with trapezoidal serrations. It should be appreciated that edges 462 and 464 may include serrations of other geometries, as described below in conjunction with Figures 6A, 6B and 6C.

Drive bay covers 452 and 454 are configured to be connected to chassis 410 for covering portions of drive bay opening 450. In one embodiment, drive bay covers 452 and 454 are configured to be connected to chassis 410 by a connector, such as a screw, a rivet, a locking tab, or any other connector means. Edge 462 is adjacent to edge 464, such that a gap between edge 462 and 464 is less than a wavelength of a high frequency EMI emission. Therefore, high frequency EMI emissions are not able to escape through chassis 410 through drive bay opening 450.

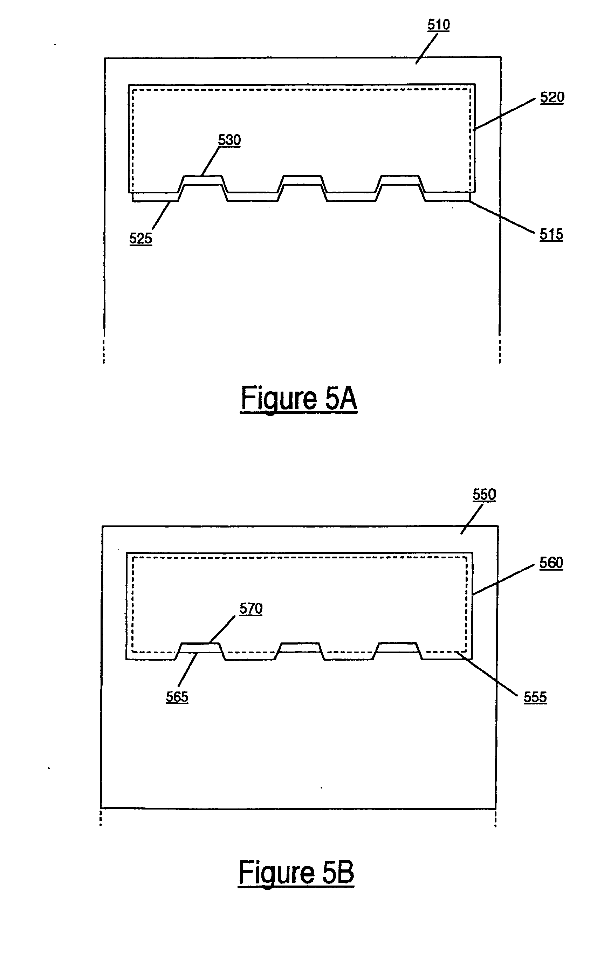

Figure 5A is a diagram of a front view of a computer system chassis 510 including a drive bay opening 515 having a serrated edge 525. Drive bay cover 520 is configured to be connected to chassis 510. In one embodiment, drive bay cover 520 is configured to be connected to chassis 510 by a connector, such as a screw, a rivet, a locking tab, or any other connector means. Drive bay cover 520 has a serrated edge 530 with trapezoidal serrations. It should be appreciated that edges 525 and 530 may include serrations of other geometries, as described below in conjunction with Figures 6A, 6B and 6C. Edge 525 is adjacent to edge 530, such that a gap between edge 525 and 530 is less than a wavelength of a high frequency EMI emission. Therefore, high frequency EMI emissions are not able to escape through chassis 510 through drive bay opening 520.

Figure 5B is a diagram of a front view of a computer system chassis 550 including a drive bay opening 555 having a linear edge 565. Drive bay cover 560 is configured to be connected to chassis 550. In one embodiment, drive bay cover 560 is configured to be connected to chassis 550 by a connector, such as a screw, a rivet, a locking tab, or any other connector means. Drive bay cover 560 has a serrated edge 570 with trapezoidal serrations. It should be appreciated that edge 570 may include serrations of other geometries, as described below in conjunction with Figures 6A, 6B and 6C. Edge 565 overlaps edge 570, such that a gap between edge 565 and 570 is less than a wavelength of a high frequency EMI emission. Therefore, high frequency EMI emissions are not able to escape through chassis 550 through drive bay opening 560.

While the embodiments described in Figures 4, 5A and 5 5B include drive bay openings and drive bay covers having serrated edges with trapezoidal serrations, it should be appreciated that the serrated edges may include any shape of serration. Figures 6A, 6B and 6C include examples of drive bay covers having serrations of various geometries that can be used in the previous described embodiments.

Figure 6A is a diagram of a drive bay cover 610 having a serrated edge 620 and with rectangular serrations 630. Figure 6B is a diagram of a drive bay cover 640 having a serrated edge 650 and with triangular serrations 660. Figure 6C is a diagram of a drive bay cover 670 having a serrated edge 680 and with sinusoidal serrations 690. It should be appreciated that many other geometries of serrations may be implemented, and are not limited to the described embodiments.

Various embodiments of the present invention provide a computer system housing, a computer system chassis, and a drive bay cover for reducing high frequency EMI emissions. The drive bay cover is configured to cover a drive bay opening and includes a serrated edge that, in conjunction with a second edge, provides that a gap between the serrated edge and the second edge is less than a wavelength of a high frequency EMI emission. Since the wavelength is longer than the length of the gap, the EMI emission is not able to escape the drive bay opening. Thus, the present invention provides a drive bay cover for reducing high frequency EMI emissions, thereby reducing RF interference with electronic devices proximate to the computer system.

Embodiments of the present invention, a drive bay cover for reducing high frequency EMI emissions, are thus described. While the present invention has been described in particular embodiments, it should be appreciated that the present invention should not be construed as limited by such embodiments, but rather construed according to the following claims.

The disclosures in United States patent application No. 10/970,893, from which this application claims priority, and in the abstract accompanying this application are incorporated herein by reference.

## Claims

1. A drive bay cover (160) for covering a bay (152) of a computer system chassis (130) by coupling to said computer system chassis (130), wherein at least one edge of said drive bay cover (160) provides a serrated edge (530) such that a gap between said serrated edge (530) and a second edge is less than a wavelength of an electromagnetic interference emission.

2. A drive bay cover according to claim 1, wherein said second edge is an edge (525) of said bay (515) of said computer system chassis (130).

3. A drive bay cover according to claim 1, wherein said second edge is an edge (436) of a second drive bay cover (424) for covering a second bay of said computer system chassis (130).

4. A drive bay cover according to claim 1, wherein said second edge is a second serrated edge (525) including serrations of a similar geometry to serrations of said serrated edge 530.

5. A drive bay cover according to any preceding claim, wherein said serrated edge (530) includes rectangular serrations (630).

6. A drive bay cover according to any one of claims 1 to 4, wherein said serrated edge (530) includes triangular serrations (660).

7. A drive bay cover according to any one of claims 1 to 4, wherein said serrated edge 530 includes sinusoidal serrations 690.

8. A computer system housing (100) including:
a chassis (130) for holding electronic componentry (140) of said computer system, said chassis (130) including at least one bay (152) for holding a portion of said electronic componentry (140); and
at least one drive bay cover (160) for covering said bay (152) by coupling to said chassis (130), wherein at least one edge of said drive bay cover (160) is provided with a serrated edge (530) such that a gap between said serrated edge (530) and a second edge is less than a wavelength of an electromagnetic interference emission.

9. A computer system housing (100) according to claim 8, wherein said second edge is an edge (525) of said bay (152) of said chassis (130).

10. A computer system housing (100) according to claim 8, wherein said second edge is an edge (436) of a second drive bay cover (424).
